# EUROPÄISCHE PATENTSCHRIFT

(11) **EP 3 120 090 B1**
(45) Veröffentlichungstag und Bekanntmachung des Hinweises auf die Patenterteilung: **03.10.2018**
(21) Anmeldenummer: 15713401.6
(22) Anmeldetag: 17.03.2015
(51) Int. Cl.: F25B 23/00, F28F 19/00, F28D 15/02

(54) **PASSIVER ZWEIPHASEN-KÜHLKREISLAUF**
PASSIVE TWO-PHASES COOLING SYSTEM
CIRCUIT PASSIF DE REFROIDISSEMENT A DEUX PHASES

(30) Priorität: 19.03.2014 DE 102014205086
(43) Veröffentlichungstag der Anmeldung: 25.01.2017
(73) Patentinhaber: Framatome GmbH, 91052 Erlangen (DE)
(72) Erfinder: FUCHS, Thomas, 50389 Wesseling (DE); ORNOT, Leo, 90449 Nürnberg (DE); RECK, Markus, 91056 Erlangen (DE); REUTER, Matthias, 04539 Groitzsch (DE)
(74) Vertreter: Tergau & Walkenhorst Patentanwälte PartGmbB
(86) Internationale Anmeldenummer: PCT/EP2015/055529
(87) Internationale Veröffentlichungsnummer: WO 2015/140151

(56) Entgegenhaltungen:
- US-A- 4 314 601
- US-B1- 6 477 847

## Beschreibung

Die Erfindung betrifft einen passiven Zweiphasen-Kühlkreislauf gemäß dem Oberbegriff des Anspruchs 1.

Zweiphasige Wärmetransportsysteme, bei denen das in einem Kreislauf geführte Kühlmittel (auch Kältemittel genannt) einen Phasenübergang von flüssig nach gasförmig und wieder zurück durchläuft, ermöglichen im Vergleich zu Einphasen-Kreisläufen bei geringen treibenden Temperaturdifferenzen hohe Wärmetransportraten. Jedoch weisen die zweiphasigen Systeme deutlich mehr Freiheitsgrade auf und sind daher komplizierter in ihrer Beherrschbarkeit als die einphasigen Systeme. Diese gilt in besonderem Maße für passive Systeme, die ohne aktive Mittel zur Strömungsbeeinflussung wie elektrische Pumpen oder dergleichen auskommen, und bei denen der Transport des Kühlmittels vielmehr ausschließlich durch die herrschenden Temperaturunterschiede zwischen der zugeordneten Wärmequelle und Wärmesenke bewirkt wird. Insbesondere stellen irreguläre Druckfluktuationen und Druckschläge, speziell kondensationsinduzierte Druckstöße im Leitungssystem ein existentielles Problem dar, da in diesem Zusammenhang extreme mechanische Beanspruchungen auftreten können. Diese führen im schlimmsten Fall zu einer Zerstörung des Systems. US4314601 A1 offenbart einen passiven Zweiphasen-Kühlkreislauf gemäß dem Oberbegriff des Anspruchs 1.

Der Erfindung liegt die Aufgabe zugrunde, einen Kühlkreislauf der Eingangs genannten Art derart weiterzuentwickeln, dass bei einfach und kostengünstig gehaltenem Aufbau des Systems Druckschläge während des Betriebs reduziert oder sogar vollständig verhindert werden.

Diese Aufgabe wird erfindungsgemäß gelöst durch einen Kühlkreislauf mit den Merkmalen des Anspruchs 1.

Wesentlicher Bestandteil der Apparatur ist ein Dämpfungsbehälter, auch Entkopplungsbehälter genannt, mit einem für den speziellen Auslegungsfall anzupassenden Volumen und mindestens vier Anschlüssen für die zum Verdampfer und zum Kondensator hinführenden und die von ihnen wegführenden Leitungen des Kühlkreislaufs. Zudem ist an dem Anschluss für den Kondensatorrücklauf ein rohrartig geformtes Bauteil angebracht, welches die Bildung einer Flüssigkeitssäule ermöglicht. Diese Flüssigkeitssäule bewirkt eine Beruhigung der Strömung in transienten Bereichen, indem sie als hydrodynamischer Schwingungsdämpfer fungiert. Des Weiteren wird durch die Flüssigkeitssäule eine Druckreduktion am Ausgang des Kondensators erreicht, woraus eine Erhöhung der treibenden Druckdifferenz im Kondensator und somit ein erhöhter Massenstrom resultiert.

Zusammengefasst können die bislang gefürchteten Druckschläge in passiven Zweiphasen-Systemen durch die vorgeschlagene Apparatur, die als fluiddynamischen Schwingungsdämpfer wirksam ist, reduziert oder sogar vollständig verhindert werden. Weiterhin wird durch die geänderten Druckverhältnisse im Kreislauf eine gerichtete Strömung induziert bzw. stabilisiert (Minimierung bzw. Eliminierung von sekundären Rückströmungen), die treibende Druckdifferenz im Kondensator vergrößert, der den Wärmetransport bewerkstelligende Massenstrom erhöht und somit im Ergebnis eine signifikante Leistungssteigerung erzielt.

Mit anderen Worten erreicht die vorgeschlagene Modifikation eines Zweiphasen-Kühlkreislaufs durch eine passive Stabilisierung und eine Leistungssteigerung einen deutlich robusteren Betrieb und daher eine erhöhte Praxistauglichkeit gegenüber bisherigen Systemen. Durch die gesteigerte Leistungsdichte des zweiphasigen Systems können große Wärmemengen bei geringen treibenden Temperaturdifferenzen passiv abgeführt werden, die einphasig nicht realisierbar sind.

Potentielle Anwendungen sind beispielsweise im nuklearen Bereich die Wärmeabfuhr aus Nasslagern, die Komponentenkühlung (etwa bei Pumpen, Dieselaggregaten, Transformatoren), die Containmentkühlung und die Kühlung von Räumen mit einer elektrisch induzierten Wärmelast. Natürlich sind auch vielfältige Anwendungen im nicht-nuklearen Bereich möglich.

Die Flüssigkeitsdichtung ist im Innenraum des Dämpfungsbehälters angeordnet, insbesondere als dessen integraler oder in ihm vormontierter Bestandteil, was die Montage des Gesamtsystems erleichtert.

In einer ersten vorteilhaften Variante weist die auch als Siphon bezeichnete Flüssigkeitsdichtung einen U-, S-, oder J-förmigen Rohrabschnitt auf, wie er beispielsweise im Bereich von Haushaltsinstallationen geläufig ist.

In einer zweiten vorteilhaften Variante ist die Flüssigkeitsdichtung dadurch verwirklicht, dass ein Rohr bzw. Rohrende in einen es seitlich umschließenden, oben zum Innenraum des Dämpfungsbehälters hin offenen Behälter bzw. ein Gefäß eintaucht, so dass die Ausbildung einer Flüssigkeitssäule möglich ist.

In bevorzugter Ausgestaltung münden die Verdampferzuleitung und die Verdampferableitung in die Bodenregion des Dämpfungsbehälters ein, und zwar vorzugsweise in einigem Abstand zueinander. Dadurch ist sichergestellt, dass einerseits das über die Verdampferableitung einströmende Gemisch aus flüssigem und verdampftem Kühlmittel sich in dem Dämpfungsbehälter separieren kann, und dass andererseits das sich in der Bodenregion sammelnde flüssige Kühlmittel einfach und ungehindert in die Verdampferzuleitung abfließen kann.

Die Kondensatorzuleitung hingegen mündet bevorzugt in die Deckenregion des Dämpfungsbehälters ein, so dass der sich über dem flüssigen Kühlmittel sammelnde Dampf einfach und ungehindert in diese Leitung einströmen kann.

Zur Unterstützung des Naturumlaufs im Kühlkreislauf ist der Dämpfungsbehälter vorzugsweise unterhalb des Kondensators angeordnet, wobei die Kondensatorableitung - von dem die Flüssigkeitsdichtung enthaltenden Abschnitt gegebenenfalls abgesehen - zumindest überwiegend als Fallrohr ausgebildet ist.

Die mit der Erfindung erzielten Vorteile bestehen insbesondere darin, dass durch eine Entkopplung der Kreisläufe von Verdampfer und Kondensator und durch die Realisierung eines fluiddynamischen Schwingungsdämpfers regulierende Maßnahmen in einem passiven System verwirklicht sind, um eine stabile und gerichtete Strömung im Verdampfer und Kondensator zu etablieren.

Ein Ausführungsbeispiel der Erfindung wird nachfolgend anhand von Zeichnungen näher erläutert. Dabei zeigt in jeweils stark vereinfachter und schematisierter Form:
- FIG. 1: einen passiven zweiphasigen Kühlkreislauf gemäß dem Stand der Technik,
- FIG. 2: einen passiven zweiphasigen Kühlkreislauf gemäß der Erfindung, und
- FIG. 3: eine alternative Variante zu einem Ausschnitt aus FIG. 2.

Gleiche oder gleichwirkende Teile sind in allen Figuren mit denselben Bezugsteichen versehen.

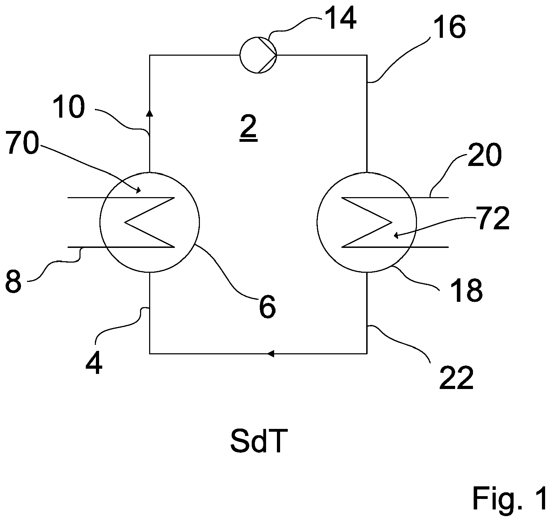

FIG. 1 gibt einen schematischen Überblick über einen konventionellen Kühlkreislauf 2, wie er in vielfältigen technischen Anwendungen eingesetzt wird, bei denen es um den Abtransport von überschüssiger Wärme aus erwärmten Anlagenbereichen geht. Die Strömungsrichtungen der beteiligen Fluide sind jeweils durch Strömungspfeile veranschaulicht.

Ein in einem Kreislauf geführtes Kühlmittel tritt zunächst in flüssiger Form über eine Verdampferzuleitung 4 (auch Verdampferzulauf oder Speiseleitung genannt) in einen Verdampfer 6 ein. Der Verdampfer 6 ist als Wärmetauscher ausgebildet, der über eine thermisch angekoppelte Wärmequelle 70, hier rein beispielhaft in Gestalt einer ein Heizmedium führenden Heizleitung 8, beheizt wird. Durch Wärmeübertrag von der Wärmequelle 70 wird das Kühlmittel im Verdampfer 6 zumindest teilweise verdampft. Der so erzeugte Kühlmitteldampf verlässt den Verdampfer 6 über eine Verdampferableitung 10 (auch auch Verdampferrücklauf oder Dampfleitung genannt).

Weiter stromabwärts tritt der Kühlmitteldampf über eine Kondensatorzuleitung 16 (auch Kondensatorzulauf genannt) in einen Kondensator 18 ein. Der Kondensator 18 ist als Wärmetauscher ausgestaltet, der thermisch an eine Wärmesenke 72, hier rein beispielhaft in Gestalt einer ein Kühlmedium führenden Kühlleitung 20, angekoppelt ist. Durch Wärmeübertrag an die Wärmesenke 72 wird der Kühlmitteldampf in dem Kondensator 18 kondensiert. Das auf diese Weise wieder verflüssigte Kühlmittel verlässt den Kondensator 18 über eine Kondensatorableitung 22 (auch Kondensatorrücklauf genannt), welche weiter stromabwärts in die Verdampferzuleitung 4 übergeht, so dass der Kreislauf dort von neuem beginnt.

Im Falle eines Kühlkreislaufes mit Zwangsströmung ist zwischen die Verdampferableitung 10 und die Kondensatorzuleitung 16 eine Pumpe 14 zum Transport des Kühlmittels geschaltet.

Für diverse Anwendungen ist der Kühlkreislauf 2 jedoch bevorzugt als passiver Kreislauf ausgebildet, der ohne aktive Komponenten, insbesondere ohne Pumpen auskommt. In diesem Fall geht die Verdampferableitung 10 direkt in die Kondensatorzuleitung 16 über. Dabei wird der Kreislauf des Kühlmittels nach dem Prinzip des Naturumlaufs durch den Temperaturunterschied zwischen Wärmequelle 70 und Wärmesenke 72 bewirkt. Dazu sind die beteiligten Komponenten in geeigneter geodätischer Höhe zueinander angeordnet und die jeweiligen Leitungsquerschnitte etc. geeignet zu bemessen. Das Kühlmittel ist hinsichtlich seiner Siedetemperatur in geeigneter Weise auf die Kombination aus Temperartur- und Druckverhältnissen im Kühlkreislauf 2 abgestimmt, so dass die die gewünschte Verdampfung im Verdampfer 6 und die Kondensation im Kondensator 18 tatsächlich stattfinden. Aufgrund der Phasenwechsel des Kühlmittels von flüssig nach gasförmig und zurück spricht man von einem zweiphasigen Kühlkreislauf.

Zweiphasige Wärmetransportsysteme ermöglichen bei geringen treibenden Temperaturdifferenzen hohe Wärmetransportraten. Jedoch stellen Druckschläge bzw. Kondensationsschläge ein existentielles Problem dar, da extreme mechanisehe Beanspruchungen auftreten können. Diese führen im schlimmsten Fall zu einer Zerstörung des Systems.

Aufgrund der instationären und zum Teil chaotischen Prozesse in den strömungsführenden Komponenten kann es nämlich zu starken Fluktuationen bzw. Schwingungen im System kommen, so dass dampfführende Strömungsbereiche in Bereiche mit kälteren Wandtemperaturen verschoben werden. Dann kommt es unter Umständen zu einer schlagartigen Kondensation des Dampfes und somit zu den genannten Kondensationsschlägen.

Man kann dies grob wie folgt verstehen: Wenn sich eine Dampfblase in einer Rohrleitung des Verdampfers bildet, findet eine starke Auskühlung der Umgebung statt. Besonders interessant ist eine zyklische Auskühlung der Rohrwand. Das heißt, die Wand braucht wieder einige Zeit, um sich aufzuwärmen und die notwendige Überhitzung zu erreichen. Lokal sind somit starke Fluktuationen vorhanden, die mit einer bestimmten Frequenz schwingen. Da im Verdampferrohr unterschiedliche Siedebereiche vorhanden sind, die mit unterschiedlichen Frequenzen schwingen, ergibt sich selbst bei einem global stationären Zustand lokal ein instationärer Zustand. Da in passiven Systemen die lokalen Siedebedingungen jedoch auch für die Antriebskraft der Strömung zuständig sind, sind immer Strömungsfluktuationen vorhanden. Im schlechtesten Fall entsteht lokal oder global eine Resonanz und das gesamte System fällt in einen sehr ungünstigen Zustand (mit eventuell deutlich verringerter Wärmeabfuhr).

Zudem besteht noch folgender Nachteil: Je nachdem, auf welchem Niveau die Wärmesenke liegt, kann es im Kondensator zu einer Unterkühlung des Kondensats kommen. Die unterkühlte Flüssigkeit muss im Verdampfer erst wieder auf Siedetemperatur gebracht werden. Da jedoch der einphasige Wärmeübergang deutlich schlechter ist als der zweiphasige Übergang, wird das Potential des Verdampfers nur unzureichend ausgenutzt.

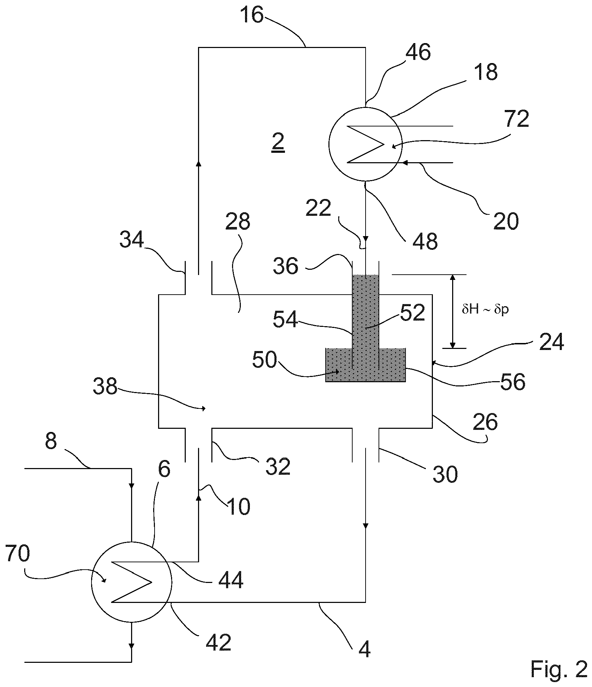

Derartige Phänomene werden erfindungsgemäß durch die in FIG. 2 vorgeschlagene Apparatur reduziert oder sogar komplett verhindert. Die folgende Beschreibung baut auf der Beschreibung von FIG. 1 auf und konzentriert sich auf die nunmehr vorgenommenen Modifikationen des Kühlkreislaufs 2.

Wesentliches Element der Modifikation ist der in den Kühlkreislauf 2 eingebundene, in Verbindung mit einer Flüssigkeitssäule als fluiddynamischer Schwingungsdämpfer wirksame Dämpfungsbehälter 24, der im Hinblick auf seine Funktion zur Entkopplung der Verdampfer- und Kondensatorkreisläufe auch als Entkopplungsbehälter bezeichnet werden kann (siehe unten). Der Dämpfungsbehälter 24 weist einen allseitig von einer Umfassungswand 26 druckdicht gegenüber der Umgebung verschlossenen Innenraum 28 auf, dessen Volumen im Hinblick auf die ihm zugeordneten Haupt-Aufgaben Schwingungsdämpfung und Medienführung hinreichend groß bemessen ist. Ferner sind vier funktionell voneinander verschiedene Anschlüsse 30, 32, 34, 36 vorgesehen, die in spezifischer Weise mit dem Leitungssystem des Kühlkreislaufs 2 verbunden sind. Während des Betriebs des Kühlkreislaufs 2 sammeln sich in dem Innenraum 28 des Dämpfungsbehälters 24 flüssiges Kühlmittel sowie Kühlmitteldampf, wobei die flüssige Phase infolge der wirkenden Schwerkraft sich nach unten zur Bodenregion 38 hin absetzt und die gas-/ dampfförmige Phase sich darüber zur Deckenregion 40 hin sammelt.

Ein erster Anschluss 30 ist in der Bodenregion 38 des Dämpfungsbehälters 24, insbesondere direkt im Boden, durch die Umfassungswand 26 geführt. Er ist mit der zum Verdampfereinlass 42 führenden Verdampferzuleitung 4 verbunden, so dass während des Betriebs in der Bodenregion 38 sich ansammelndes flüssiges Kühlmittel über den Anschluss 30 und die Verdampferzuleitung 4 zum Verdampfer 6 strömt, wo die Verdampfung des Kühlmittels erfolgt.

An einen zweiten Anschluss 32, der ebenfalls in der Bodenregion 38 des Dämpfungsbehälters 24, insbesondere direkt im Boden, ggf. etwas höher durch die Umfassungswand 26 geführt ist, ist die vom Verdampferauslass 44 kommende Verdampferableitung 10 angeschlossen. Im Allgemeinen wird das Kühlmittel im Verdampfer 6 nicht vollständig, sondern nur teilweise verdampft, und das entstehende Gemisch aus flüssigem Kühlmittel und Kühlmitteldampf wird somit über die Verdampferableitung 10 und den Anschluss 32 in den Innenraum 28 des Dämpfungsbehälters 24 geleitet, wo wie bereits beschrieben eine Phasenseparation erfolgt.

Ein dritter Anschluss 34 ist in der Deckenregion 40 des Dämpfungsbehälters 24, insbesondere direkt in der Decke, durch die Umfassungswand 26 geführt. An ihn ist die zum Kondensatoreinlass 46 führende Kondensatorzuleitung 16 angeschlossen, so dass in der Deckenregion 40 sich ansammelnder Kühlmitteldampf über den Anschluss 34 und die Kondensatorzuleitung 16 zum Kondensator 18 strömt, wo die Kondensation des Kühlmitteldampfes erfolgt.

Schließlich ist ein vierter Anschluss 36 in der Deckenregion 40 des Dämpfungsbehälters 24, insbesondere direkt in der Decke, durch die Umfassungswand 26 geführt. An ihn ist die vom Kondensatorauslass 48 kommende Kondensatorableitung 22 angeschlossen, so dass das im Kondensator 18 verflüssigte Kühlmittel über die Kondensatorableitung 22 und den Anschluss 36 in den Dämpfungsbehälter 24 strömt.

Bei den zuerst genannten drei Anschlüssen 30, 32, 34 münden die angeschlossenen Rohrleitungen 4, 10, 16 insofern direkt in den Innenraum des Dämpfungsbehälters 24, als bei normalbetrieblichen Strömungsverhältnissen ein Druckausgleich zwischen dem Innenraum 28 und diesen Rohrleitungen 4, 10, 16 möglich ist. Im Unterschied hierzu ist der vierte Anschluss 36 derart beschaffen, dass die daran angeschlossene Rohrleitung, nämlich die Kondensatorableitung 22 unter Ausbildung einer Flüssigkeitsdichtung 50 in den Innenraum 28 des Dämpfungsbehälters 24 einmündet. Eine derartige Flüssigkeitsdichtung 50 wird auch als Siphon oder Trap bezeichnet. Durch die sich im Betrieb des Kühlkreislaufs 2 ausbildende Flüssigkeitssäule 52 aus flüssigem Kühlmittel wird der Durchlass von Gasen unterbunden oder jedenfalls erschwert, so dass eine Druckseparation zwischen dem Innenraum 28 und der Kondensatorableitung 22 verwirklich ist. Die Höhe 5H der sich einstellenden Flüssigkeitssäule 52 korreliert dabei zu der herrschenden Druckdifferenz δp.

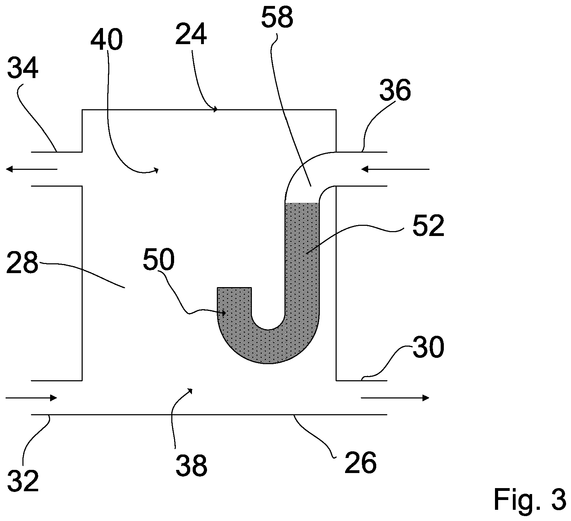

Die Flüssigkeitsdichtung 50 ist erfindungsgemäss in einem Rohrabschnitt im Innenraum 28 des Dämpfungsbehälters 24 verwirklicht und kann jede für die Funktion zweckmäßige Form annehmen. Beispielsweise kann sie wie in FIG. 2 dargestellt ein Rohrende 54 aufweisen, welches von oben in einen nach oben hin offenen Behälter 56 eintaucht. Alternativ oder zusätzlich können die bekannten U-, S-, oder J-förmigen Rohrabschnitte 58 oder funktionell äquivalente Ausführungen zum Einsatz kommen, wie in FIG. 3 exemplarisch anhand eines J-Bogens dargestellt.

Über die Flüssigkeitssäule 52 des Siphons werden der Rückstrom des Dampfes sowie die Dämpfung des Systems realisiert. Das heißt, in Abhängigkeit von den zu erwartenden Systeminstabilitäten muss die Flüssigkeitssäule 52 realisiert werden. In FIG. 2 weist die nach oben weisende Öffnung des umliegenden Behälters 56 eine deutlich größere Querschnittsfläche als das eintauchende Rohr 54 auf. Das heißt, eine kleine Höhendifferenz im Behälter 56 realisiert eine deutlich größere Höhendifferenz im Rohr 54 (entsprechend der Flächenverhältnisse). Da die gesamte Höhendifferenz δH mit der Druckdifferenz δp korreliert, wird den Druckschwankungen im System entgegengewirkt. Die Einbauhöhe des Siphons muss auf die gesamte Bandbreite des Systems abgestimmt werden. Das heißt, bei geringen Wärmeleistungen befindet sich die flüssige Phase überwiegend im Verdampferbereich - der Behälter ist nahezu leer. Bei hohen Wärmeleistungen befindet sich relativ viel der flüssigen Phase im Behälter (durch den hohen Dampfanteil im Verdampfer). Auf dieser Basis sind die Komponenten auszulegen.

Zur Unterstützung des Naturumlaufs in dem Kühlkreislauf 2 befinden sich der Verdampfer 6, der Kondensator 18 und der Dämpfungsbehälter 24 relativ zueinander in geeigneter geodätischer Höhe. Insbesondere ist der Dämpfungsbehälter 24 bevorzugt unterhalb des Kondensators 18 angeordnet, so dass die vom Kondensator 18 zum Dämpfungsbehälter 24 führende Kondensatorableitung 22 im Wesentlichen als Fallrohr ausgestaltet ist. Unter rein hydrostatischen Gesichtspunkten wird es ferner als vorteilhaft angesehen, den Verdampfer 6 unterhalb des Dämpfungsbehälters 24 anzuordnen. Demzufolge ist die Verdampferableitung 10 bevorzugt ein Steigrohr und die Verdampferzuleitung 4 ein Fallrohr. Da es sich hier jedoch um ein fluiddynamisches System handelt, welches zudem noch eine Zweiphasigkeit aufweist, könnte es sein, dass sich in der Praxis eine abweichende Anordnung als positiv herausstellt.

Zusammengefasst wird damit bei dem Kühlkreislauf 2 gemäß FIG. 2 sowohl die vom Verdampfer 6 zum Kondensator 18 führende Leitungsschleife als auch die vom Kondensator 18 zum Verdampfer 6 führende Leitungsschleife durch den gemeinsamen Dämpfungsbehälter 24 geführt. Die Flüssigkeitssäule 52 in dem Dämpfungsbehälter 24 bewirkt zusammen mit dem durch den Innenraum 28 verwirklichten Ausgleichvolumen eine Entkopplung der Kreisläufe und eine Beruhigung der Strömung in transienten Bereichen, indem sie als hydrodynamischer Schwingungsdämpfer fungiert. Des Weiteren wird durch die Flüssigkeitssäule 52 eine auslassseitige Druckreduktion im Kondensator 18 erreicht, woraus eine Erhöhung der treibenden Druckdifferenz im Kondensator 18 und somit ein erhöhter Massenstrom in dem Kühlkreislauf 2 resultiert.

Ein weiterer Vorteil des Dämpfungsbehälters 24 liegt in einer Vorwärmung des Kondensats. Da am Verdampferauslass 44 ein (relativer) Dampfgehalt kleiner eins vorliegt, fließt ein Teil der gesättigten Flüssigkeit durch den Dämpfungsbehälter 24 wieder zum Verdampfereinlass 42 zurück. Dabei findet eine Vermischung des ggf. unterkühlten Kondensats mit der gesättigten Flüssigkeit statt. Folglich werden die Bereiche des einphasigen Wärmeübergangs im Verdampfer 6 verkleinert und der Gesamtprozess verbessert (thermodynamische Optimierung).

Die in FIG. 2 und 3 dargestellte Apparatur dient somit sowohl zur Effizienzsteigerung der Wärmeabfuhr als auch zur Reduktion von Kondensationsschlägen im Falle eines passiven Zweiphasen-Kreisprozesses.

### Bezugszeichenliste

- 2: Kühlkreislauf
- 4: Verdampferzuleitung
- 6: Verdampfer
- 8: Heizleitung
- 10: Verdampferableitung
- 14: Pumpe
- 16: Kondensatorzuleitung
- 18: Kondensator
- 20: Kühlleitung
- 22: Kondensatorableitung
- 24: Dämpfungsbehälter
- 26: Umfassungswand
- 28: Innenraum
- 30: erster Anschluss
- 32: zweiter Anschluss
- 34: dritter Anschluss
- 36: vierter Anschluss
- 38: Bodenregion
- 40: Deckenregion
- 42: Verdampfereinlass
- 44: Verdampferauslass
- 46: Kondensatoreinlass
- 48: Kondensatorauslass
- 50: Flüssigkeitsdichtung
- 52: Flüssigkeitssäule
- 54: Rohrende
- 56: Behälter
- 58: Rohrabschnitt
- 70: Wärmequelle
- 72: Wärmesenke

## Patentansprüche

1. Passiver Zweiphasen-Kühlkreislauf (2) mit einem Verdampfer (6) und einem Kondensator (18) für ein in dem Kühlkreislauf (2) geführtes Kühlmittel, wobei an den Verdampfer (6) eine Verdampferzuleitung (4) und eine Verdampferableitung (10) angeschlossen sind, und wobei an den Kondensator (18) eine Kondensatorzuleitung (16) und eine Kondensatorableitung (22) angeschlossen sind, wobei ferner die Verdampferzuleitung (4), die Verdampferableitung (10), die Kondensatorzuleitung (16) und die Kondensatorableitung (22) an einen gemeinsamen Dämpfungsbehälter (24) angeschlossen sind, wobei sich in der Kondensatorableitung (22) beim Betrieb des Kühlkreislaufs (2) eine Flüssigkeitssäule (52) aus flüssigem Kühlmittel ausbildet, die die Funktion einer Flüssigkeitsdichtung (50) sowie die Funktion eines fluiddynamischen Schwingungsdämpfers übernimmt,
**dadurch gekennzeichnet, dass**
die Kondensatorableitung (22) in die Deckenregion (40) des Dämpfungsbehälters (24) einmündet und einen in den Innenraum (28) des Dämpfungsbehälters (24) hinein ragenden Rohrabschnitt aufweist, in dem die Flüssigkeitsdichtung (50) verwirklicht ist.

2. Kühlkreislauf (2) nach Anspruch 1, wobei die Flüssigkeitsdichtung (50) einen U-, S-, oder J-förmigen Rohrabschnitt (58) aufweist.

3. Kühlkreislauf (2) nach einem der Ansprüche 1 bis 2, wobei die Flüssigkeitsdichtung (50) ein Rohrende (54) aufweist, welches in einen nach oben hin offenen Behälter (56) eintaucht.

4. Kühlkreislauf (2) nach einem der Ansprüche 1 bis 3, wobei die Verdampferzuleitung (4) und die Verdampferableitung (10) in die Bodenregion (38) des Dämpfungsbehälters (24) einmünden.

5. Kühlkreislauf (2) nach einem der Ansprüche 1 bis 4, wobei der Dämpfungsbehälter (24) unterhalb des Kondensators (18) angeordnet ist, und wobei die Kondensatorableitung (22) überwiegend als Fallrohr ausgebildet ist.

## Claims

1. A passive two-phase cooling circuit (2) having a vaporiser (6) and a condenser (18) for a coolant conducted in the cooling circuit (2), a vaporiser supply line (4) and a vaporiser discharge line (10) being connected to the vaporiser (6), and a condenser supply line (16) and a condenser discharge line (22) being connected to the condenser (18), the vaporiser supply line (4), the vaporiser discharge line (10), the condenser supply line (16) and the condenser discharge line (22) further being connected to a common damping container (24), a liquid column (52) of liquid coolant forming in the condenser discharge line (22) during operation of the cooling circuit (2), which liquid column (52) assumes the function of a liquid seal (50) and the function of a fluid-dynamic vibration damper
**characterised in that**
the condenser discharge line (22) feeds into the cover region (40) of the damping container (24) and comprises a pipe portion projecting into the internal space (28) of the damping container (24), in which the liquid seal (50) is realized.

2. The cooling circuit (2) of claim 1, wherein the liquid seal (50) comprises a U, S or J-shaped pipe portion (58).

3. The cooling circuit (2) of any of claims 1 to 2, wherein the liquid seal (50) comprises a pipe end (54) which is immersed in a container (56) which is open at the top.

4. The cooling circuit (2) of any of claims 1 to 3, wherein the vaporiser supply line (4) and the vaporiser discharge line (10) feed into the base region (38) of the damping container (24).

5. The cooling circuit (2) of any of claims 1 to 4, wherein the damping container (24) is arranged below the condenser (18), and wherein the condenser discharge line (22) is predominantly in the form of a downpipe.

## Revendications

1. Circuit de refroidissement (2) passif à deux phases ayant un évaporateur (6) et un condensateur (18) pour un fluide de refroidissement conduit dans le circuit de refroidissement (2), une conduite d'alimentation d'évaporateur (4) et une conduite d'évacuation d'évaporateur (10) étant reliées à l'évaporateur (6), et une conduite d'alimentation de condensateur (16) et une conduite d'évacuation de condensateur (22) étant reliées au condensateur (18), la conduite d'alimentation d'évaporateur (4), la conduite d'évacuation d'évaporateur (10), la conduite d'alimentation de condensateur (16) et la conduite d'évacuation de condensateur (22) étant en outre reliées à un réservoir d'amortissement (24) commun, une colonne de liquide (52) d'un fluide de refroidissement liquide formant dans la conduite d'évacuation de condensateur (22) en fonctionnement du circuit de refroidissement (2), laquelle assume la function de dispositif d'étanchéité liquide (50) et la function d'amortisseur de vibrations dynamique fluidique
**caractérisé en ce que**
la conduite d'évacuation de condensateur (22) débouche dans la région de plafond (40) du réservoir d'amortissement (24) et comprend une partie de tuyau entrant dans l'espace intérieur (28) du réservoir d'amortissement (24), dans lequel le dispositif d'étanchéité liquide (50) est réalisé.

2. Circuit de refroidissement (2) selon la revendication 1, dans lequel le dispositif d'étanchéité liquide (50) comprend une partie de tuyau (58) en U, S ou J.

3. Circuit de refroidissement (2) selon l'une quelconque des revendications 1 à 2, dans lequel le dispositif d'étanchéité liquide (50) comprend un bout de tuyau (54) plongé dans un récipient (56) qui est ouvert en haut.

4. Circuit de refroidissement (2) selon l'une quelconque des revendications 1 à 3, dans lequel la conduite d'alimentation d'évaporateur (4) et la conduite d'évacuation d'évaporateur (10) débouchent dans la région de plancher (38) du réservoir d'amortissement (24).

5. Circuit de refroidissement (2) selon l'une quelconque des revendications 1 à 4, dans lequel le réservoir d'amortissement (24) est disposé au-dessous du condensateur (18) et dans lequel la conduite d'évacuation de condensateur (22) est conçue principalement en tant que tuyau de descente.
